# FASCICULE DE BREVET EUROPEEN

(11) **EP 4 568 464 B1**
(45) Date de publication et mention de la délivrance du brevet: **18.11.2026**
(21) Numéro de dépôt: 24216411.9
(22) Date de dépôt: 29.11.2024
(51) Int. Cl.: H10N 50/01, H10N 50/10, H10N 50/80

(54) **PROCÉDÉ DE FABRICATION D'UNE MÉMOIRE À EFFET DE COUPLE DE SPIN-ORBITE ET MÉMOIRE CORRESPONDANT**
VERFAHREN ZUR HERSTELLUNG EINES SPIN-ORBIT-DREHMOMENT-SPEICHERS UND ENTSPRECHENDER SPEICHER
METHOD FOR MANUFACTURING A SPIN-ORBIT-TORQUE MEMORY AND CORRESPONDING MEMORY

(30) Priorité: 04.12.2023 FR 2313524
(43) Date de publication de la demande: 11.06.2025
(73) Titulaire: Commissariat à l'Energie Atomique et aux Energies Alternatives, 75015 Paris (FR); Université Grenoble Alpes, 38400 Saint-Martin-d'Hères (FR); Centre National de la Recherche Scientifique, 75016 Paris (FR); Institut Polytechnique de Grenoble, 38000 Grenoble (FR)
(72) Inventeur: VIALA, Bernard, 38054 GRENOBLE CEDEX 09 (FR); GARELLO, Kévin, 38054 GRENOBLE CEDEX 09 (FR); HUTIN, Louis, 38054 GRENOBLE CEDEX 09 (FR); DELAET, Bertrand, 38054 GRENOBLE CEDEX 09 (FR); BIAGI, Marco, 50141 FIRENZE (IT)
(74) Mandataire: Cabinet Camus Lebkiri

(56) Documents cités:
- EP-A1- 3 442 030
- WO-A1-2023/112087
- US-A1- 2018 351 084

## Description

### DOMAINE TECHNIQUE DE L'INVENTION

Le domaine technique de l'invention est celui du stockage de données dans une mémoire et plus particulièrement une mémoire magnétique non volatile à effet de couple spin-orbite (dit « SOT » pour « Spin-Orbit Torque » en anglais).

### ARRIÈRE-PLAN TECHNOLOGIQUE DE L'INVENTION

Les mémoires magnétiques non-volatiles utilisent par exemple une jonction tunnel magnétique (dite « JTM » ou « jonction tunnel » ou encore « MTJ » pour « Magnetic Tunnel Junction » en anglais) constituée de deux couches magnétiques séparées par une couche isolante non magnétique. L'une des couches magnétiques est dite « couche piégée » ou « couche de référence » car elle présente une aimantation fixe. L'autre couche magnétique est dite « couche libre » ou « couche de stockage » car elle présente une aimantation variable pouvant prendre des valeurs ou des orientations distinctes. La couche isolante non magnétique est dire « barrière tunnel » car elle joue le rôle de barrière tunnel lors du transport électronique entre les deux couches magnétiques. L'orientation relative de l'aimantation de la couche libre par rapport à l'aimantation de la couche de référence permet de stocker une information. La différence de résistance de la jonction tunnel permet de lire l'information stockée (c'est-à-dire l'orientation d'une aimantation par rapport à l'autre). Par exemple, une configuration parallèle des aimantations correspond à un état de résistance électrique minimale et par exemple à un état bas, c'est-à-dire un bit de donnée 0. La configuration antiparallèle des aimantations correspond à un état de résistance maximale et par exemple à un état haut, c'est-à-dire un bit de donnée 1. La différence relative s'exprime en pourcentage de magnétorésistance tunnel (dite « TMR » pour « Tunnel MagnetoResistance » en anglais) qui est habituellement de l'ordre de 100 % à 150 % pour des jonctions usuelles dites « top pinned » et de l'ordre de 150 % à 200 % pour des jonctions usuelles dites « bottom pinned ». Les couches piégée et libre possèdent le plus souvent des orientations d'aimantation qui sont perpendiculaires par rapport au plan des couches. On parle alors de jonction magnétique tunnel perpendiculaire ou « pMTJ » pour « perpendicular magnetic tunnel junction » en anglais.

Une première génération de mémoires magnétiques repose sur un effet de transfert de couple de spin (dit « STT » pour « Spin Transfer Torque » en anglais) pour modifier l'orientation de l'aimantation de la couche libre et écrire un état spécifique dans la jonction tunnel. Le transfert de couple de spin repose sur la circulation d'un courant électrique traversant la jonction tunnel. La jonction tunnel est donc usuellement reliée à deux terminaux.

Une seconde génération de mémoires magnétiques repose sur un effet de couple spin-orbite également appelé « effet de couple spin-orbital » ou encore « SOT » pour « Spin-Orbit Torque » en anglais. Une mémoire SOT comprend, en plus de la jonction tunnel, une piste d'écriture dite également « piste SOT », le plus souvent réalisée dans un métal de transition lourd tel que Pt ou β-W. L'effet SOT est un phénomène qui permet de transmettre un couple au niveau d'une interface. La piste SOT est donc disposée directement en contact avec la couche libre de la jonction tunnel. La circulation d'un courant électrique dans la piste SOT, et pas à travers la jonction tunnel, permet de générer un courant de spin (différent d'un courant électronique) qui peut exercer un couple sur l'aimantation de la couche libre et réaliser l'écriture d'un état. L'effet SOT offre l'avantage de séparer les chemins de circulation de courant pour réaliser la lecture (circulant à travers la jonction tunnel) et l'écriture d'un état dans la jonction tunnel (circulant uniquement dans la piste SOT). Les jonctions tunnel opérées par SOT nécessitent trois terminaux. Deux d'entre eux relient la piste SOT, pour réaliser l'écriture, et un troisième relie la jonction tunnel, à l'opposé de la piste SOT, pour réaliser la lecture de l'état de la jonction.

Bien que moins compacte que les mémoires STT, les mémoires SOT offrent une plus grande endurance parce que le courant électrique d'écriture parcourt uniquement la piste SOT et ne traverse plus la barrière tunnel (celle-ci n'est plus que traversée par le courant de lecture qui est toujours plus faible que le courant d'écriture). Elles peuvent également être plus rapides car leur temps d'écriture par effet SOT peut être plus court (compris entre 0,3 ns et 1 ms) que celui accessible par effet STT (compris entre 10 ns et 100 ns). Enfin, les mémoires SOT sont dotées d'une meilleure performance énergétique (en consommation électrique par jonction). Ces avantages orientent donc l'utilisation des mémoires SOT, et des mémoires vives qui en découlent (dites « SOT-MRAM » pour « SOT Magnetic Random Access Memory » en anglais), vers des applications embarquées ou de type « cache » (mémoire à laquelle un microprocesseur accède plus rapidement et plus fréquemment lors de calculs). Par exemple, les SOT-MRAM ont pour vocation de remplacer les mémoires vives statiques telles que les « Embedded SRAM » qui n'ont pas d'alternative à ce jour. Cependant, les procédés de fabrications des mémoires SOT et des SOT-MRAM sont plus complexes et ne sont pas encore totalement maitrisés.

L'un des problèmes à résoudre est la réalisation de la piste SOT et de la jonction par un procédé devant préserver l'intégrité des couches minces constituant les deux éléments et en particulier l'interface entre la piste SOT et la couche libre. En effet, l'écriture par SOT requiert généralement un contact direct et sans dégradation de l'interface entre la couche libre et la piste SOT.

Le document US2020/0136024 A1 divulgue un dispositif magnétique alternatif comprenant un élément magnétique et une piste SOT qui ne sont pas directement en contact. Ce dispositif comprend un espaceur métallique séparant la piste SOT et l'élément magnétique, présentant une longueur de diffusion de spin et une conductivité élevées. L'espaceur permet ainsi de collecter et diffuser le courant de spin généré par la piste SOT vers l'élément magnétique. L'espaceur présente la particularité de présenter une surface plus étendue que la surface de l'élément magnétique de manière à former un entonnoir pour courants de spin issus de la piste SOT.

La fabrication de ce dispositif comprend le dépôt de l'ensemble des couches nécessaires à la réalisation de la piste SOT dans un premier temps et de l'espaceur dans un second temps. L'espaceur est ensuite délimité par une gravure anisotrope avec un arrêt sur la couche en matériau SOT. La piste SOT est délimitée par une seconde gravure à travers un second masque dur. Le masque ayant servi à délimiter l'espaceur est ensuite nécessairement retiré avant le dépôt et la délimitation de l'élément magnétique.

L'arrêt de la gravure de l'espaceur est une étape critique et un mauvais contrôle de cet arrêt peut endommager la piste SOT. En effet, cette dernière peut présenter une épaisseur de quelques dizaines de nanomètres, voire quelques nanomètres seulement. Elle peut donc être facilement sectionnée rendant le dispositif inutilisable. Cette méthode requiert également le recours à deux étapes de gravure.

La demande US 2017/0117323 A1 décrit un procédé de fabrication d'une mémoire SOT, permettant de résoudre le risque de sectionnement de la piste SOT lors de la délimitation par gravure de la jonction tunnel tout en conservant une interface entre la couche libre et la piste SOT de bonne qualité. Pour cela, il est proposé de renverser l'ordre des couches de manière à déposer et délimiter la jonction tunnel dans un premier temps et déposer et délimiter la piste SOT dans un second temps. La mémoire SOT est dite « bottom-pinned », c'est-à-dire que la couche libre est disposée au niveau de la tête de la jonction, pour être en contact avec la couche SOT. Si la délimitation de la jonction tunnel ne pose plus de risque pour la piste SOT, elle requiert la formation d'une couche de transition en matériau SOT, au contact de la couche libre et avant la délimitation de la jonction tunnel. Ainsi la couche de transition protège l'interface avec la couche libre pendant la délimitation de la jonction tunnel et permet la reprise de contact de la piste SOT. La couche de transition et la jonction tunnel sont délimitée à l'aide du même masque dur qui est ensuite nécessairement retiré.

La piste SOT est donc en contact avec la couche libre par l'intermédiaire de la couche de transition. Toutefois, même si cette dernière est en matériau SOT, elle réduit tout de même l'efficacité d'écriture car la forme des lignes de courant électrique circulant dans la couche de transition réduit l'efficacité de génération de courants de spin. De plus, la couche de transition est disposée sur le chemin de circulation du courant lors de la lecture. La jonction peut donc présenter une résistance totale plus élevée et peut présenter une vitesse de lecture réduite.

La demande US 2018/0123031 A1 décrit un procédé similaire à celui exposé ci-dessus. Toutefois, à la différence du procédé précité, une reprise de contact est réalisée sur la jonction tunnel, non pas par la piste SOT en elle-même, mais par une piste conductrice qui connecte la couche de transition. Le rôle de piste SOT est alors assuré par la couche de transition en matériau SOT. La couche de transition et la jonction tunnel sont délimitée à l'aide d'un même masque dur qui est ensuite nécessairement retiré.

Toutefois, pour conserver une bonne efficacité d'écriture, il est nécessaire que la piste conductrice ne court-circuite par la couche de transition. Ceci requiert une étape de gravure de la piste conductrice pour retirer les portions qui pourraient induire un court-circuit. La formation de la piste conductrice qui connecte la couche de transition est donc complexe à réaliser et présente un risque pour le bon fonctionnement de la mémoire.

Les documents US2018/351084A1 et WO2023/112087A1 décrivent des mémoires SOT comportant un espaceur séparant la jonction tunnel magnétique de la piste SOT au-dessus, ainsi que leurs procédés de fabrication.

Il existe donc un besoin de fournir un procédé de fabrication d'une mémoire SOT qui soit plus simple à exécuter et qui offre une mémoire présentant une efficacité de commutation au moins équivalente aux mémoires SOT de l'art antérieure (c'est-à-dire présentant une interface au niveau de laquelle est exercée l'effet SOT qui soit maximisé).

### RÉSUME DE L'INVENTION

Pour cela, l'invention concerne un procédé de fabrication d'une mémoire à effet de couple de spin, dite « mémoire SOT », selon la revendication 1, comprenant, à partir d'un substrat, les étapes suivantes :
- déposer un empilement magnétique destiné à former, après délimitation, une jonction tunnel magnétique, l'empilement magnétique comprenant une première couche magnétique présentant, après délimitation, une aimantation libre ;
- déposer une couche conductrice sur l'empilement magnétique et directement contre la première couche magnétique, la couche conductrice présentant une longueur de diffusion de spin ;
- graver un espaceur dans la couche conductrice de manière anisotrope à travers un premier masque de gravure avec arrêt sur l'empilement magnétique ;
- graver l'empilement magnétique de manière à délimiter la jonction tunnel magnétique, la gravure étant réalisée de manière anisotrope en employant l'espaceur comme deuxième masque de gravure, l'espaceur présentant, après gravure, une épaisseur finale inférieure à sa longueur de diffusion de spin ; et
- former, sur l'espaceur et directement contre cet espaceur, une piste dite « piste SOT », à partir d'un matériau présentant un couplage spin-orbite.

Par « couche conductrice », on entend une couche dont la conductivité électrique est supérieure à 10⁶ S/m dans des conditions standard.

Par « déposé directement contre la première couche magnétique », on entend déposé au contact de cette première couche magnétique, sans couche intermédiaire.

Par « épaisseur d'une couche », on entend une dimension de la couche mesurée perpendiculairement au substrat.

Par « piste », on entend une couche présentant une longueur et une largeur, mesurées parallèlement au substrat, sa longueur étant plus grande que sa largeur.

Ce procédé permet de former un point mémoire comprenant une jonction tunnel magnétique et une piste SOT séparées par un espaceur. Après délimitation de la jonction tunnel magnétique en employant l'espaceur comme deuxième masque de gravure, la première couche magnétique forme une couche magnétique, dite « couche libre », présentant une aimantation dite « libre », pouvant commuter entre au moins deux configurations distinctes. L'espaceur est en contact direct avec la couche libre. La circulation d'un courant dans la piste SOT permet de créer une accumulation de spin à la surface de la piste SOT. Cette accumulation permet de générer un courant de spin dans l'espaceur qui est au contact de la piste SOT. L'espaceur permet à ce courant de spin de se propager vers la jonction tunnel et plus particulièrement dans la couche libre. Puisque la longueur de diffusion de spin est plus grande que la distance séparant la piste SOT de la jonction tunnel, une partie significative du courant de spin atteint la jonction tunnel. Ce courant de spin peut donc exercer un couple de spin-orbite au niveau de l'interface entre l'aimantation libre et l'espaceur. Ce courant de spin permet de réaliser une écriture d'un état dans la mémoire. L'espaceur permet donc de délocaliser l'effet de couple spin-orbite de la piste SOT.

L'interface au niveau de laquelle est réalisé l'effet SOT est l'interface de la couche libre recevant le courant de spin, c'est-à-dire l'interface partagée entre la jonction tunnel et l'espaceur. L'espaceur peut donc, après avoir été déposé sur la première couche magnétique, protéger l'interface de cette première couche magnétique au niveau de laquelle s'exerce le couple de spin-orbite. De cette façon, cette interface conserve une qualité optimale, quelle que soit les étapes ultérieures de fabrication mises en œuvre, par exemple pour former la piste SOT ou des terminaux conducteurs.

De plus, la distanciation offerte par l'espaceur permet de relâcher la contrainte sur la fabrication de la piste SOT. Il est par exemple possible de recourir à des matériaux dont les procédés de fabrication ne sont pas compatibles avec ceux d'une couche magnétique ou d'une jonction tunnel magnétique à proximité immédiate. La piste SOT peut également être réalisée dans un second temps, sans qu'une dégradation de l'interface entre la jonction tunnel et l'espaceur ne soit à craindre.

L'épaisseur finale de l'espaceur n'est contrainte que par sa longueur de diffusion de spin, qui impose une épaisseur finale maximale. Dès lors, l'espaceur peut subir des étapes de fabrication agressives, telles qu'un polissage ou une gravure, pour obtenir une piste SOT ayant une forme adéquate.

À l'issue de l'étape de délimitation de la jonction tunnel, ladite jonction tunnel et l'espaceur sont délimités par un seul et même flanc.

Par matériau présentant un couplage spin-orbite, on entend un matériau générant un courant transverse de spins lorsqu'il est parcouru par un courant électrique de charges électriques longitudinal. L'efficacité de conversion charge-spin est donnée par unité de courant (sans dimension). Pour les matériaux dits « à fort couplage spin-orbit », on parle d'efficacité préférentiellement supérieur à 0,1, voire supérieur à 1 ou, de manière encore préférée, supérieur à 50.

Selon l'invention, la couche conductrice présente une épaisseur initiale h70 donnée par :
$h 70 < h 10 ′ \times v 30 / v 10 ′ + δ$
où h10' est l'épaisseur de l'empilement magnétique, v10' est la vitesse de gravure de l'empilement magnétique, v30 est la vitesse de gravure de la couche conductrice et δ est la longueur de diffusion de spin de la couche conductrice, les vitesses de gravure de l'empilement magnétique et de la couche conductrice étant considérées pour des conditions de gravure identiques. De cette manière, l'épaisseur finale de l'espaceur garantit la propagation du courant de spin généré par la piste SOT vers la jonction tunnel.

Avantageusement, la couche conductrice présente une longueur de diffusion supérieure à 20 nm et préférentiellement supérieure à 100 nm. Plus la longueur de diffusion est élevée et plus l'épaisseur finale de l'espaceur peut être élevée. Cette longueur de diffusion élevée permet également de propager une part importante du courant de spin généré par la piste SOT vers la jonction tunnel. Par exemple, la couche conductrice comprend un matériau parmi Cu, Al, Ag, Co, Au ou Ni. La couche conductrice peut, alternativement, comprendre un matériau tel que Ti et TiN. Ces derniers présentent l'avantage d'être fréquemment utilisés pour former des masques durs, leur emploi est donc maitrisé.

Selon l'invention, l'espaceur présente une épaisseur finale supérieure à 10 nm et préférentiellement supérieure à 20 nm. Cette épaisseur finale minimale garantit une distance suffisante entre la jonction tunnel et le sommet de l'espaceur pour pouvoir former la piste SOT, même avec des étapes de fabrications agressives, sans risquer de détériorer la jonction tunnel. Elle réduit également le risque de migration d'une espèce de la piste SOT vers la jonction tunnel ou de la jonction tunnel vers la piste SOT. Plus grande est l'épaisseur finale de l'espaceur et plus bas est le risque de détérioration ou de migration. De plus, une faible épaisseur finale peut impliquer une vitesse de gravure réduite, limitant le choix des matériaux pour pouvoir former l'espaceur.

Avantageusement, l'espaceur présente une vitesse de gravure inférieure à la vitesse de gravure de l'empilement magnétique, les vitesses de gravure de l'espaceur et de l'empilement magnétique étant considérées pour des conditions de gravure identiques. Autrement dit, l'espaceur est plus dur que l'empilement magnétique à graver. Ainsi, l'épaisseur initiale de l'espaceur n'a pas besoin d'être très élevée pour pouvoir résister à l'étape de gravure de l'empilement magnétique. Il y a donc moins de risque que la jonction tunnel et l'espaceur s'effondrent lors de leur propre délimitation. De plus, sa forme, et en particulier sa largeur ou son diamètre mesuré parallèlement au substrat, est mieux contrôlé lorsqu'il présente une épaisseur initiale moindre. L'espaceur présente préférentiellement une vitesse de gravure inférieure à 90% de la vitesse de gravure de l'empilement magnétique, voire inférieure à 50% de la vitesse de gravure de l'empilement magnétique et de manière encore préférée, inférieure à 20% de la vitesse de gravure de l'empilement magnétique.

Par exemple, l'espaceur comprend un alliage durci de Cu, Al, Ag, Co, Au ou Ni, tel que AgCd, CuW ou CuBr.

Avantageusement, la couche conductrice est une multicouche. Elle permet ainsi de combiner les propriétés de diffusion de spin ou de vitesse de gravure de manière à former un espaceur présentant une épaisseur initiale (avant gravure de l'empilement magnétique) réduisant le risque d'effondrement de l'espaceur et de la jonction tunnel lors de leur délimitation. Par exemple, la multicouche alterne une première couche présentant une vitesse de gravure inférieure à la vitesse de gravure de l'empilement magnétique et une deuxième couche présentant une longueur de diffusion supérieure à 20 nm. Elle permet ainsi de conjuguer plusieurs avantages de différents matériaux. Les vitesses de gravure des premières et deuxièmes couches étant considérées pour des conditions de gravure identiques.

Avantageusement, la première couche magnétique présente, après délimitation, une anisotropie magnétique perpendiculaire. Perpendiculaire s'entend relativement au plan des couches. La première couche magnétique peut également présenter une anisotropie magnétique perpendiculaire avant délimitation.

Alternativement, la première couche magnétique présente, après délimitation, une anisotropie magnétique planaire. Planaire s'entend relativement au plan des couches.

La jonction tunnel magnétique peut comprendre une deuxième couche magnétique, dite « couche de référence » présentant, après délimitation, une aimantation fixe. Selon la configuration précitée (couche libre au contact de l'espaceur), la couche de référence est disposée entre le substrat et la couche libre. Autrement dit, la jonction tunnel présente une configuration dite « bottom-pinned ». C'est-à-dire que la couche de référence est disposée sous la couche libre, en considérant le substrat comme le bas. La configuration bottom-pinned présente un avantage lors de la délimitation de la jonction tunnel par gravure. En effet, des résidus de gravures peuvent se déposer sur les parois de la jonction tunnel délimitée, au voisinage du substrat. Dans la configuration dite « top-pinned », la couche libre, généralement peu épaisse, se situe au niveau du substrat. Les résidus de gravure peuvent donc facilement court-circuiter la jonction tunnel. Dans la configuration bottom-pinned, la couche de référence, généralement plus épaisse, éloigne la couche libre du substrat et réduit le risque de court-circuit.

Avantageusement, la première couche magnétique présente un état de surface obtenu lors de son dépôt, la couche conductrice étant déposée sur la première couche magnétique de manière à conserver l'état de surface de la première couche magnétique. La première couche magnétique et l'espaceur sont par exemple déposés consécutivement sous vide, sans remise à l'air entre les deux dépôts. De cette manière, l'état de surface de la première couche magnétique est optimal.

Avantageusement, la formation de la piste SOT comprend les sous-étapes de :
- déposer une couche diélectrique recouvrant l'espaceur ;
- aplanir la couche diélectrique avec arrêt sur le sommet de l'espaceur ;
- déposer la piste SOT s'étendant en partie sur la couche diélectrique et en partie sur l'espaceur.

Par « somme d'un élément », on entend la partie la plus haute de cet élément, la hauteur étant mesurée perpendiculairement au substrat et depuis le substrat. La piste SOT s'étend donc sensiblement parallèlement au substrat. Elle s'étend surtout dans un seul est même plan. Cette configuration offre une accumulation de spin suffisante sur la surface de la piste SOT.

Alternativement, la formation de la piste SOT comprend les sous-étapes de :
- déposer une couche diélectrique recouvrant l'espaceur ;
- graver une partie de la couche diélectrique avec arrêt sur le sommet de l'espaceur de sorte que la couche diélectrique présente un flanc s'étendant perpendiculairement au substrat, dans le prolongement d'une partie d'un flanc de l'espaceur ;
- déposer la piste SOT s'étendant en partie sur la couche diélectrique et en partie sur l'espaceur, la piste SOT présentant deux portions consécutives, l'une des portions, dite « portion parallèle » s'étendant sur l'espaceur, sensiblement parallèlement au substrat et l'autre des portions, dite « portion perpendiculaire » s'étendant contre le flanc de la couche diélectrique, sensiblement perpendiculairement au substrat.

Par « sensiblement parallèlement » et « sensiblement parallèle », on entend parallèle à 20° près, voire 10° et de manière préférée à 5° près. De manière similaire, par « sensiblement perpendiculairement » et « sensiblement perpendiculaire », on entend perpendiculaire à 20° près, voire 10° et de manière préférée à 5° près.

Ainsi, la piste SOT présente une forme en **L,** avec la portion perpendiculaire qui s'étend au droit de l'espaceur en s'écartant de l'espaceur. Elle présente notamment un coin joignant la portion parallèle avec la portion perpendiculaire. Cette forme peut améliorer la diffusion de spins dans l'espaceur.

Alternativement, la formation de la piste SOT comprend les sous-étapes de :
- déposer une couche isolante contre le flanc de l'espaceur ;
- former une couche diélectrique en laissant dégagée une portion l'espaceur ;
- former un premier terminal conducteur et un deuxième terminal conducteur sur la couche diélectrique, de part et d'autre de l'espaceur, s'appuyant contre la couche isolante, les premier et deuxième terminaux étant distant l'un de l'autre ;
- former la piste SOT s'étendant sur l'espaceur en reliant électriquement les premier et deuxième terminaux.

La couche isolante permet de placer les terminaux conducteurs au plus près de l'espaceur, permettant de réduire la longueur de la piste SOT.

Avantageusement, les premier et deuxième terminaux sont formés de manière à créer respectivement une première paroi et une deuxième paroi, disposées de part et d'autre de l'espaceur, s'étendant sensiblement perpendiculairement au substrat et formant une tranchée avec l'espaceur, la piste SOT étant déposée dans la tranchée. De la sorte, la longueur de la piste SOT est limitée à l'extrême puisqu'uniquement localisée au niveau de l'espaceur. Ce mode de mise en œuvre facilite également l'alignement de la piste SOT avec l'espaceur.

Alternativement, la formation de la piste SOT comprend la sous-étape complémentaire d'aplanir les premier et deuxième terminaux avec arrêt au sommet de l'espaceur, la piste SOT étant sensiblement parallèlement au substrat, en partie sur les premier et deuxième terminaux et en partie sur l'espaceur. Ainsi, la piste SOT est plate et montre une accumulation de spin suffisante au niveau de l'espaceur.

Avantageusement, la piste SOT comprend un métal de transition lourd tel que le Pt, le Pt/Ti, le Ta et le β-W, ou un isolant topologique à base de Bi et Sb, et/ou Se et/ou Te ou un matériau dit « 2D » tel que le MoS₂ ou le WS₂ ou encore un supraconducteur à base de Nb.

L'invention concerne également une mémoire à effet de couple spin-orbite, dite « mémoire SOT », selon la revendication 15, comprenant, à partir d'un substrat :
- une jonction tunnel magnétique s'étendant sur le substrat, comprenant une première couche magnétique, dite « couche libre », présentant une aimantation libre ;
- une piste, dite « piste SOT », présentant un couplage spin-orbite ; et
- une couche conductrice, dite « espaceur », séparant la jonction tunnel de la piste SOT et s'étendant directement contre la couche libre et directement contre la piste SOT, l'espaceur présentant une une longueur de diffusion de spin strictement supérieure à son épaisseur,
la mémoire étant remarquable en ce que la jonction tunnel magnétique est « bottom-pinned ».

Par « bottom-pinned », on entend que la jonction tunnel magnétique comprend une deuxième couche magnétique dite « couche de référence » présentant une aimantation fixe, la couche de référence étant disposée entre le substrat et la couche libre.

Avantageusement, la jonction tunnel et l'espaceur sont délimités par un même flanc. Par « flanc », on entend une surface s'étendant perpendiculairement au plan des couches. À l'inverse d'une mémoire présentant une forme d'entonnoir, telle que présentée dans US 2020/013602 A1, le flanc unique permet de former une piste SOT qui soit plus courte. Dès lors la résistance de cette piste est réduite par rapport à celle de l'art antérieur.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention. Sauf précision contraire, un même élément apparaissant sur des figures différentes présente une référence unique.
Les [Fig. 1], [Fig. 2] et [Fig. 3] présentent trois modes de réalisation d'une mémoire à effet de couple spin-orbite de l'invention.
Les [Fig. 4], [Fig. 5], [Fig. 6], [Fig. 7], [Fig. 8] et [Fig. 9] présentent schématiquement différentes étapes d'un procédé de fabrication de la mémoire à effet de couple spin-orbite de la [Fig. 1].

### DESCRIPTION DÉTAILLÉE

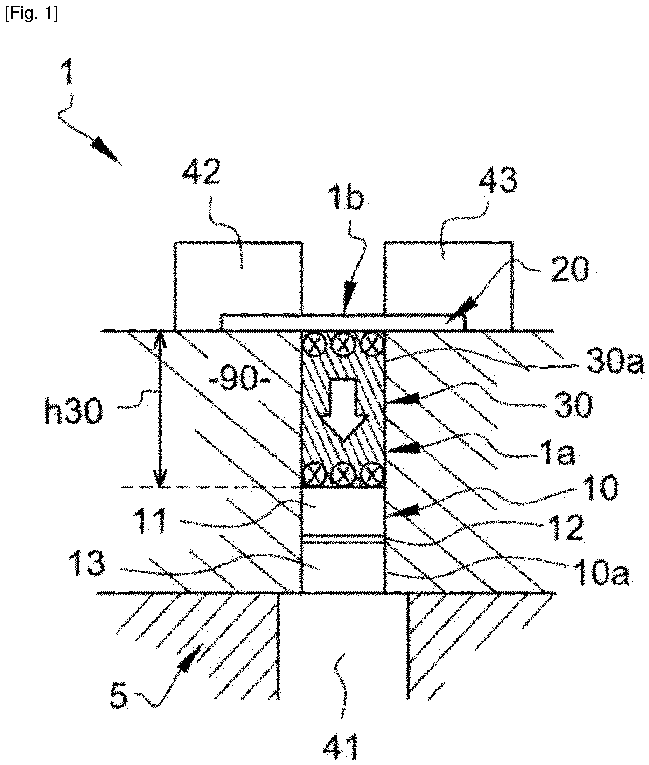

La figure 1 présente schématiquement un premier mode de réalisation d'une mémoire 1 à effet de couple spin-orbite, c'est-à-dire de type SOT.

Dans ce mode de réalisation, la mémoire 1 est reliée à un premier terminal 41 conducteur. Il s'agit par exemple d'un via conducteur traversant un substrat 5 et débouchant à la surface de celui-ci. Le premier terminal 41 peut être un via conducteur, par exemple en cuivre, chargé de réaliser le routage dans un circuit intégré, par exemple au niveau d'un bloc fonctionnel de fin de ligne, aussi appelé « backend of line » en anglais. Alternativement, le premier terminal 41 peut être un bouchon (dit « plug » en anglais), par exemple en tungstène, disposé sur le via pour bloquer la diffusion d'espèce telles que le cuivre vers les différents niveaux du back-end of line. Le substrat 5 représente par exemple un niveau du backend of line. Le substrat 5 est préférentiellement non conducteur, il s'agit par exemple d'une couche semiconductrice, par exemple en silicium, recouvert par une ou plusieurs couches diélectriques, par exemple en oxyde de silicium.

Le substrat 5, et en particulier sa surface, définit un plan de référence sur lequel sont déposées les différentes couches. Pour cette raison il est également appelé « plan des couches ». L'axe Z s'étend perpendiculairement au substrat 5. L'axe X s'étend parallèlement au substrat 5.

La mémoire 1 représentée dans la figure 1 présente deux parties 1a, 1b. Une première partie 1a de forme allongée s'étend selon une direction sensiblement perpendiculaire à la surface du substrat 5 (donc sensiblement selon Z). Cette première partie 1a repose sur le premier terminal 41. Une deuxième partie 1b, de forme aplatie, s'étend dans un plan sensiblement parallèle à la surface du substrat 5 (donc sensiblement selon X). La deuxième partie 1b repose sur la première partie 1a. La mémoire 1 présente une forme de T, reposant sur le premier terminal 41 avec lequel elle est connectée électriquement.

La première partie 1a de la mémoire 1 présente une forme pouvant être cylindrique ou ellipsoïdale ou parallélépipédique et dont la base repose sur le premier terminal 41. Elle comprend une jonction tunnel magnétique 10 et une couche 30 conductrice dite « espaceur ». Dans cet exemple, la couche conductrice 30 est non-magnétique.

La jonction tunnel magnétique 10 comprend une première couche 11 magnétique, dite « couche libre », une deuxième couche 12 non-magnétique, dite « barrière tunnel » et une troisième couche 13 magnétique dite « couche de référence ».

La couche libre 11 présente une aimantation et une anisotropie magnétique. L'anisotropie de la couche libre 11 est configurée pour stabiliser l'aimantation selon au moins deux configurations distinctes. Par exemple, l'anisotropie de la couche libre 11 peut orienter spontanément l'aimantation hors du plan des couches. L'aimantation peut par exemple être orientée sensiblement perpendiculairement au plan des couches de la couche libre 11. Elle peut alors être dirigée, en prenant l'axe Z de la figure 1 comme référence, parallèlement ou antiparallèlement à cet axe Z. L'anisotropie de la couche libre 11 peut également être telle que l'aimantation s'oriente spontanément dans le plan de la couche libre 11. L'aimantation peut également adopter une configuration de vortex ou de skyrmion ayant une polarité (c'est-à-dire un moment magnétique net) hors du plan des couches.

Ledit plan des couches est le plan dans lequel s'étendent les couches magnétiques 11, 13. Il est considéré comme étant parallèle au substrat.

La couche libre 11 peut être réalisée à partir de Fe, Co, Ni ou d'un alliage de ces éléments, par exemple CoFe, CoFeB ou encore en NiFe

La couche de référence 13 présente également une aimantation dite « aimantation de référence » et une anisotropie. L'anisotropie de la couche de référence 13 est préférentiellement configurée pour que l'aimantation de référence présente une configuration prédéterminée, par exemple selon une direction fixée et orientée dans le plan de la couche de référence 13 ou orientée hors du plan de cette couche 13. L'anisotropie de la couche de référence est préférentiellement telle que l'aimantation de référence conserve sa configuration pendant toute la durée de vie ou d'utilisation de la mémoire 1. Pour cela, l'anisotropie de la couche de référence 13 peut être renforcée au moyen d'une couche antiferromagnétique (non représentée dans la figure 1), couplée à la couche de référence 13. Il peut s'agir d'une multicouche de couches ferromagnétiques couplées les unes aux autres de manière antiparallèle, dite « couche antiferromagnétique synthétique » ou « SAF » pour « Synthetic Antiferromagnet » en anglais.

La couche de référence 13 peut être également être réalisée à partir de Fe, Co, Ni ou d'un alliage de ces éléments, tels que ceux précités pour la couche libre 11 et de multicouches comprenant par exemple des alternances de Co et de Pt

La barrière tunnel 12 est configurée pour induire un effet tunnel lors de la circulation d'une courant polarisé en spin dans la jonction tunnel 10. Ce courant est par exemple utilisé pour mesurer la configuration de l'aimantation de la couche libre 11 par rapport à l'aimantation de la couche de référence. La barrière tunnel 12 est une couche isolante et non-magnétique. Elle sépare la couche libre 11 de la couche de référence 13 et s'étend au contact de ces deux couches 11, 13. Elle peut être réalisée à partir d'oxyde, de nitrure ou d'une combinaison d'oxydes et de nitrures. Par exemple, il peut s'agir de MgO, de MgAlxOy, de AlOx, de TiOx, de HfOx, de TaOx, de AIN, ou ZnO.

La forme des couches libre 11 et de référence 13 peut contribuer à l'anisotropie magnétique de ces couches pour orienter leurs aimantations hors du plan des couches ou au contraire dans le plan des couches. La barrière tunnel 12 peut également contribuer à l'anisotropie magnétique de la couche libre 11 et/ou de la couche de référence. Lorsqu'elle est constituée de MgO, elle induit une anisotropie interfaciale hors plan au contact de couches en CoFe ou de CoFeB. Cette anisotropie interfaciale est avantageusement utilisée pour orienter l'aimantation de la couche libre 11 hors du plan des couches.

La jonction tunnel 10 peut également comprendre des couches supplémentaires, non-représentées sur la figure 1. Il s'agit par exemple d'une couche d'adaptation, aussi appelée « seed layer » en anglais, permettant de privilégier un réseau cristallin lors de la croissance des couches formant la jonction tunnel 10. Elle peut être réalisée en Ta, Pt, Wou encore en MgO.

L'espaceur 30 est un conducteur qui repose sur la jonction tunnel 10. Il s'étend dans le prolongement de la jonction tunnel 10, sensiblement perpendiculairement au substrat 5. L'espaceur 30 est plus particulièrement au contact direct de la couche libre 11. Par « contact direct », on entend que l'espaceur 30 et la couche libre 11 partage une interface commune. L'espaceur 30 comprend au moins deux faces, opposées l'une à l'autre. L'une des deux faces de l'espaceur 30 est donc en contact direct avec la couche libre 11 de la jonction 10.

La deuxième partie 1b de la mémoire 1 s'étend sur l'espaceur 30 et au contact direct de cet espaceur 30. Dans cet exemple, elle s'étend également sur une couche diélectrique 90 entourant la première partie 1a. La deuxième partie 1b comprend une piste conductrice 20 dite « piste SOT ». Cette piste SOT 20 s'étend sensiblement parallèlement au substrat 5. Elle s'étend à l'aplomb de la première partie 1a et au-delà de cette première partie 1a, sur la couche diélectrique 90.

La piste SOT 20 est au contact direct de l'espaceur 30. Elle présente par exemple une face qui est en contact direct avec l'une des deux faces de l'espaceur 30, avantageusement celle qui est opposée à la face de l'espaceur 30 en contact avec la jonction 10. Ainsi, l'espaceur 30 sépare la jonction 10 de la piste 30 et réalise un contact électrique entre les deux.

La piste SOT 20 est configurée pour, lorsqu'elle est parcourue par un courant électrique, induire un courant de spin dans l'espaceur 30. Le courant de spin est à différencier d'un courant d'électrons polarisés en spin. Il s'agit, dans le cas présent, d'un courant n'impliquant pas le déplacement de charges mais au contraire la circulation d'une polarisation particulière des spins portés par ces charges (la polarisation des spins étant matérialisée par les croix cerclées dans la figure 1). La circulation d'une courant électrique dans la piste SOT 20, sensiblement parallèlement au substrat 5, génère un courant de spin (matérialisé par la flèche épaisse dans la figure 1) se propageant dans l'espaceur 30, perpendiculairement au substrat 5, en direction de la jonction tunnel 10.

La piste SOT 20 comprend un matériau présentant un couplage spin-orbit. Cette condition peut être obtenue au moyen de métaux de transitions lourds, tels que Pt, β-W, Ta, Hf, Ir, CuBi, CuIr ou encore AuW. En cela, la piste SOT 20 est comparable aux pistes SOT de l'art antérieur à la différence que la piste SOT 20 selon de la figure 1 s'étend intégralement de manière planaire et au-dessus de la jonction tunnel.

La piste SOT 20 est connectée à deux terminaux 42, 43 conducteurs permettant la circulation d'un courant électronique.

La génération d'un courant de spin dans l'espaceur 30 est un phénomène interfacial. Le contact direct de la piste SOT 20 sur l'espaceur 30 permet la génération du courant de spin dans l'espaceur 30. Il est avantageux que la piste SOT 20 et l'espaceur 30 partage donc une interface commune grande et de bonne qualité pour générer efficacement le courant de spin.

Afin d'agir sur l'aimantation de la couche libre 11 par effet SOT, il est nécessaire que l'espaceur 30 puisse transférer une partie au moins du courant de spin induit par la piste SOT 20 jusqu'à la jonction tunnel 10 et en particulier jusqu'à la couche libre 11. Pour cela, l'espaceur présente une longueur de diffusion de spin δ (aussi appelée « longueur de diffusion cohérente de spin ») et une épaisseur h30 (également appelée hauteur), mesurée perpendiculairement au substrat 5 (ou, de manière équivalente, au plan des couches), telles que :
$h 30 < δ$

La longueur de diffusion de spin correspond à une longueur qu'un courant de spin peut parcourir dans un matériau avant d'être significativement absorbé. En limitant l'épaisseur h30 de l'espaceur 30 à une valeur inférieure à la longueur de diffusion de spin δ, une partie du courant de spin induit par la piste SOT 20 est effectivement transférée à la couche libre 11 (l'espaceur 30 étant en contact direct avec la couche libre 11).

Le courant de spin réalise l'effet de couple spin-orbite (dit « SOT ») pouvant agir sur l'aimantation de la couche libre 11. Il s'agit d'un effet interfacial (ayant lieu dans la longueur de diffusion de spin de part et d'autre de l'interface). Le contact direct de l'espaceur 30 avec la couche libre 11 permet ainsi l'action de l'effet SOT sur l'aimantation de la couche libre 11.

Le [Tableau 1] ci-dessous dresse une liste de matériaux ainsi que leurs longueurs de diffusion δ respectives. Les matériaux pouvant être sélectionnés pour former l'espaceur 30 présentent avantageusement une longueur de diffusion δ supérieure à 20 nm. Ils permettent ainsi de former un espaceur 30 pouvant atteindre une hauteur h30 pouvant atteindre 20 nm, voire plus.

Les matériaux présentant une longueur de diffusion δ supérieure ou à 20nm, voire supérieure à 50 nm, voire supérieure à 100 nm, sont à privilégier pour former l'espaceur 30. Ainsi, un espaceur 30 de grande taille peut être formé, pouvant atteindre 20 nm voire 100 nm, voire davantage, en bénéficiant tout de même d'un effet SOT significatif sur l'aimantation de la couche libre 11.

**[Tableau 1]**

| Matériaux | Longueur de diffusion de spin δ (en nanomètres) |
|---|---|
| Al, Cu | 350 |
| Ag | 130 |
| Co | 40 |
| Au | 32 |
| Ni | 21 |
| Pt, Ru | 14 |
| CoFe | 12 |
| Fe | 8 |
| W | 5 |
| TiN, TaN | 2 |

L'espaceur 30 permet d'espacer la piste SOT 20 de la jonction tunnel 10 tout en autorisant la propagation d'un courant de spin généré par la piste SOT 20. Il permet ainsi de délocaliser l'effet SOT de la piste SOT 20. De plus, l'espaceur 30 permet également de facilité la formation de la piste SOT 20 tout en garantissant une interface de bonne qualité pour l'action de l'effet SOT sur l'aimantation de la couche libre 11. En effet, l'espaceur 30 peut être formé en même temps que la jonction tunnel 10. Par exemple, les couches qui forment la jonction tunnel 10 peuvent être déposées dans un premier temps et l'espaceur 30 peut être déposé sur ces couches dans un second temps. Ces dépôts peuvent être avantageusement réalisés dans un même environnement, par exemple sous vide. Ainsi l'interface entre la jonction tunnel 10 et l'espaceur 30 est protégé par l'espaceur. L'état de surface de la couche libre 11 reste optimal et exempt de toute pollution ou particules pouvant dégrader cet état de surface, quelques soit les étapes de fabrication ultérieures.

L'effet SOT recherché pour réaliser l'écriture dans la mémoire 1 se produit au niveau de l'interface séparant la couche libre 11 de l'espaceur 30. Il faut donc que cette interface présente une bonne qualité. En revanche, l'interface entre l'espaceur 30 et la piste SOT 20 est beaucoup moins critique. La face de l'espaceur 30 sur laquelle vient s'étendre la piste SOT 20 peut résulter d'un polissage mécanique et/ou chimique sans que cela n'ait d'impact significatif sur l'efficacité de l'écriture. Il est toutefois préférable que la rugosité de surface soit inférieure à 1 nm RMS.

Puisque l'espaceur 30 protège l'interface avec la couche libre 11, il peut être envisagé d'utiliser des matériaux difficilement intégrables, voire présentant une incompatibilité de croissance avec une jonction tunnel 10 à proximité immédiate, pour former la piste SOT 20. Il peut s'agir de matériaux montrant des propriétés d'isolant topologique ou de matériaux 2D ou des matériaux supraconducteurs.

L'espaceur 30 selon l'invention présente la particularité d'être placé sur les chemins permettant de réaliser l'écriture et la lecture dans la mémoire 1. En effet, il est disposé sur le chemin de courant de spin, lors de l'écriture, et sur le chemin de courant polarisé en spin traversant la jonction 10 lors de la lecture. L'espaceur 30 est alors avantageusement choisi pour présenter une conductivité électrique élevée, avantageusement supérieure à celle de la piste SOT 20. Elle est par exemple supérieure à 10⁶ S/m voire préférentiellement supérieure à 10⁷ S/m. Par exemple, considérant la piste SOT 20 composé de β-W, l'espaceur 30 peut avantageusement comprendre du Ag, Au, Cu, Ni, Co ou encore du α-W.

La hauteur h30 de l'espaceur 30 pouvant être paramétrable, elle peut être ajustée pour répondre au besoin en matière de fabrication et notamment pour réaliser une piste SOT 20 qui soit plane, c'est-à-dire sensiblement parallèle au plan des couches. Il faut toutefois veiller à ce que la hauteur h30, après fabrication de la mémoire, soit inférieure à la longueur de diffusion δ.

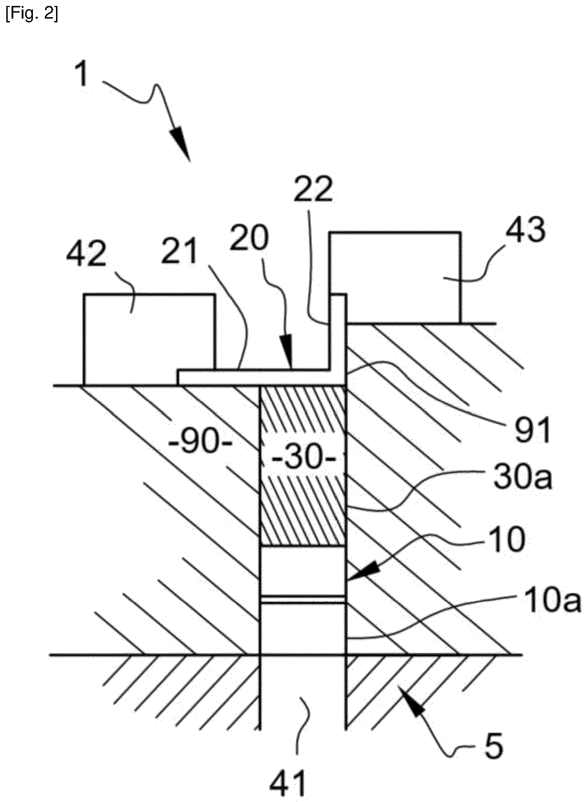

La figure 2 présente schématiquement un deuxième mode de réalisation de la mémoire 1. À la différence du mode de réalisation de la figure 1, la deuxième partie 1b, comprenant la piste SOT 20, ne s'étend pas sensiblement parallèlement au substrat 5. Elle présente au contraire une forme en L. La piste SOT 20 présente deux portions consécutives : une première portion 21, dite « portion parallèle », s'étendant sensiblement perpendiculairement au substrat 5 et au contact de l'espaceur 30 et une deuxième portions 22, dite « portion perpendiculaire » s'étendant perpendiculairement au substrat 5, dans le prolongement du flanc 30a de l'espaceur 30. Cette forme en L améliore la diffusion de spin et dans l'espaceur 30.

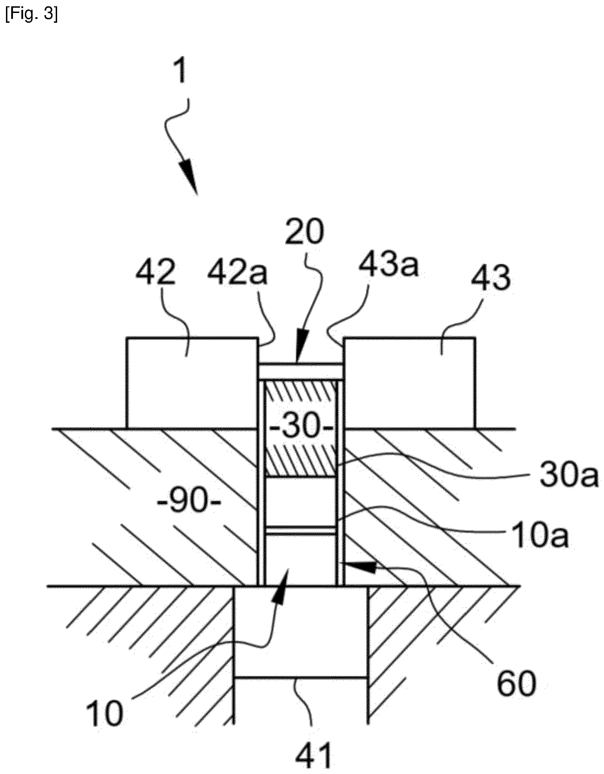

La figure 3 présente schématiquement un troisième mode de réalisation de la mémoire 1. À la différence du premier mode de réalisation de la figure 1, les deuxième et troisième terminaux 42, 43 viennent au contact de la première partie de la mémoire 1. La longueur de la piste SOT 20 s'en trouve réduite. La première partie 1a de la mémoire 1 présente sur son flanc 10a, 30a, une couche isolante 60. Par « flanc », on entend une surface latérale 10a, 30a délimitant le pourtour de la mémoire 1. La couche isolante 60 a pour objectif d'isoler électriquement la première partie 1a de la mémoire 1 des deuxième et troisième terminaux 42, 43. Ces terminaux 42, 43 sont uniquement connectés à la piste SOT 20. La couche isolante 60 peut recouvrir une portion seulement du flanc 10a, 30a de la première partie 1a. Il s'agit au moins de la portion de flanc en regard des deuxième et troisième terminaux 42, 43. Par exemple, la couche isolante 60 peut recouvrir uniquement le flanc 30a de l'espaceur 30.

La couche isolante 60 peut être formée par oxydation du flanc de la première partie 1a de la mémoire 1. Elle peut également être formée par dépôt conforme d'un diélectrique ou par dépôt conforme d'un semiconducteur qui est oxydé par la suite. Il faut toutefois veiller à protéger la surface supérieure de l'espaceur 30 si la couche isolante 60 est formée avant la piste SOT. Alternativement, la couche isolante 60 est formée après la formation de la piste SOT.

Dans l'exemple illustré par la figure 3, les deuxième et troisième terminaux 42, 43, plaqués contre l'espaceur 30 (et en l'occurrence contre la couche isolante 60), forment une cavité au fond de laquelle s'étend la piste SOT 20, connectant les deux terminaux. Chacun des terminaux 42, 43 présente une paroi 42a, 43a s'étendant dans le prolongement d'une partie du flanc 30a de l'espaceur 30. Ces parois 42a, 43a forment ainsi les parois de la tranchée. Alternativement, les deux terminaux 42, 43 peuvent être disposés de part et d'autre de la première partie 1a de la mémoire 1, en affleurant l'espaceur 30. La piste SOT 20 s'étend alors de manière plane sur les deux terminaux 42, 43 et le sommet de l'espaceur 30.

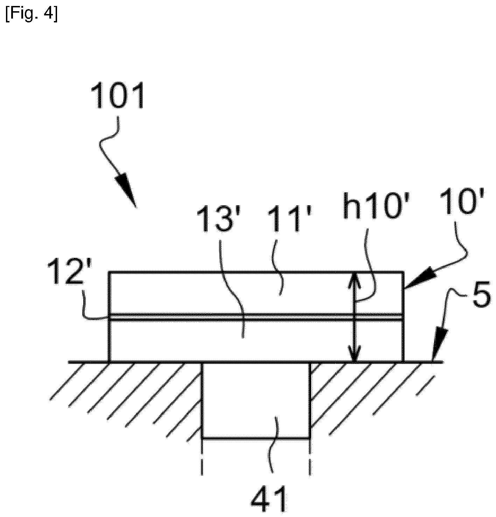

Les figures 4 à 9 présentent schématiquement un mode de mise en œuvre d'un procédé de fabrication permettant d'obtenir la mémoire 1 de la figure 1. Le procédé de fabrication peut être réalisé à partir d'un substrat 5, tel que présenté dans la figure 4, s'étendant dans un plan, confondu avec un plan dit « plan de couches », parallèle au substrat 5. Le substrat 5 est par exemple en Si. Dans ce mode de mise en œuvre, un premier terminal 41 traverse en partie le substrat 5 et débouche sur sa surface par une ouverture. Le sommet du premier terminal 41 affleure la surface du substrat 5. Le premier terminal 41 peut être un via, un bouchon de type « BEOL » (pour « Back End Of Line » en anglais) ou encore d'une piste s'étendant en partie dans le substrat 5.

Une première étape du procédé, illustré par la figure 4, consiste à déposer 101 un empilement magnétique 10' sur le substrat 5. Cet empilement comprend des première, deuxième et troisième couches 11, 12, 13 qui sont destinées à former les couches 11, 12, 13 de la jonction tunnel 10. Ce dépôt 101 comprend par exemple le dépôt de deux couches magnétiques 11', 13' séparées par une couche isolante 12'. La première couche magnétique 11' est par exemple destinée à former, une fois délimitée, la couche libre 11 de la jonction tunnel 10. Le procédé peut également comprendre un dépôt initial de couches destinées à former une couche seed et/ou un antiferromagnétique synthétique (non représentées dans cette figure), tel que discutées précédemment.

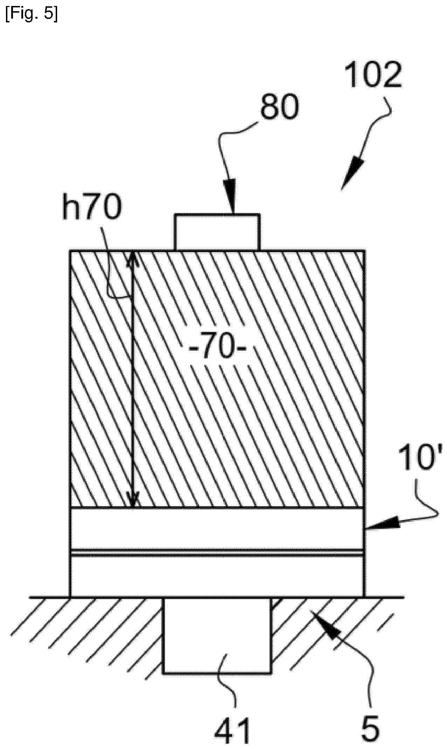

Le procédé comprend ensuite le dépôt 102 d'une couche conductrice destinée à former l'espaceur 30, illustrée par la figure 5. La couche conductrice 70 comprend par exemple un matériau offrant une grande longueur de diffusion de spin, telle que discutée plus haut. Il s'agit par exemple de Cu. La couche conductrice 70 est déposée directement au contact de l'empilement magnétique 10' et plus particulièrement de la première couches magnétique 11'. Le dépôt 102 est par exemple réalisé au moyen d'une méthode de dépôt par voie physique. D'autres méthodes de dépôt peuvent être envisagées, telles qu'un dépôt par voie chimique.

L'empilement 10' et la couche conductrice 70 sont avantageusement déposés dans deux étapes successives. Ainsi, l'état de surface de la première couche magnétique 11', fraichement déposée, peut être protégé par la couche conductrice 70. L'atmosphère dans laquelle sont déposées ces différentes couches est préférentiellement conservée. Les dépôts sont par exemple réalisés sous vide ou dans une atmosphère de gaz neutre, sans remise à l'air entre ces dépôts. Ainsi, la qualité de l'état de surface de la première couche magnétique 11' est conservé et protégée par la couche conductrice 70. Ce dépôt permet ainsi de garantir une interface entre la couche libre 11 de la jonction tunnel 10 et l'espaceur 30 de très bonne qualité.

Le procédé peut comprendre un recuit, réalisé après le dépôt 101 de l'empilement magnétique 10' et de la couche conductrice 70. Par exemple, lorsque la première couche magnétique 11' de l'empilement 10' est en CoFeB et la couche isolante 12' en MgO, le recuit permet d'améliorer l'interface entre ces deux couches et augmenter l'anisotropie magnétique hors plan entre ces deux couches 11', 12'. Il peut en résulter, après délimitation de la jonction, une couche libre 11 présentant une anisotropie perpendiculaire. Le recuit peut également améliorer l'interface entre la première couche magnétique 11' et la couche conductrice 70. Le recuit peut également être réalisée après gravure de la couche conductrice 70 et de l'empilement magnétique 10'.

La couche conductrice 70 est déposée avec une première épaisseur h70, mesurée perpendiculairement au substrat 5, dite « épaisseur initiale » ou « hauteur initiale ». Elle dépend de la vitesse de gravure du matériau utilisé pour former cette couche 70 ainsi que la vitesse de gravure de l'empilement magnétique 10'. De manière générale, par « vitesse de gravure », on entend une vitesse à laquelle est gravée une couche. Cette vitesse de gravure s'apprécie dans des conditions reproductibles de gravure. La comparaison entre deux vitesses de gravure est donc réalisée pour des conditions identiques de gravure. En effet, la vitesse de gravure dépend fortement de ou des espèces utilisées comme élément de gravure ou de la composition des fluides ou gaz utilisées pour réaliser la gravure. De plus, comme l'empilement magnétique 10' peut comprendre des couches dont les vitesses de gravures sont différentes, la vitesse de gravure considérée est la vitesse moyenne des vitesses de gravures des couches de l'empilement 10'.

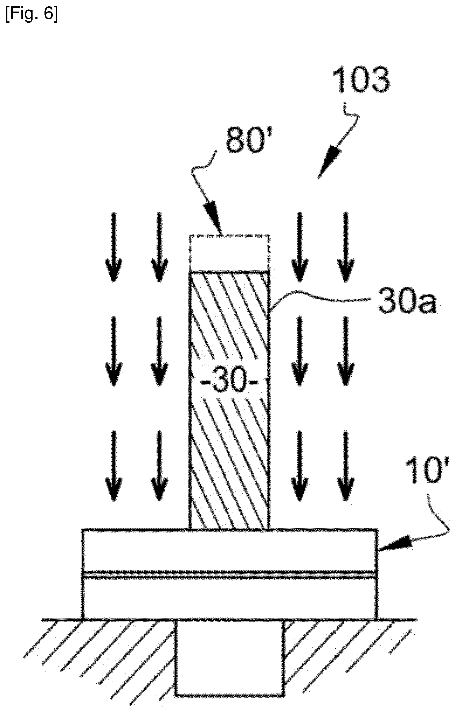

La figure 6 présente une étape de délimitation 103 de la couche conductrice 70 de manière à former l'espaceur 30. Cette délimitation est réalisée par gravure anisotrope à travers un premier masque 80, par exemple en résine. La gravure 103 est arrêtée sur l'empilement 10'. Le masque 80, par exemple en résine, est formé par photolithographie sur l'espaceur 30. L'épaisseur initiale h70 de la couche conductrice 70 est conservée lors de l'étape de délimitation 103. Elle n'est donc pas égale à l'épaisseur finale h30 de l'espaceur 30 telle que présentée dans la figure 1, mais au contraire supérieure.

La gravure 103 de l'espaceur 30 peut être alignée avec le premier terminal 41 de sorte que la mémoire résultante 1 soit connectée à ce terminal 41.

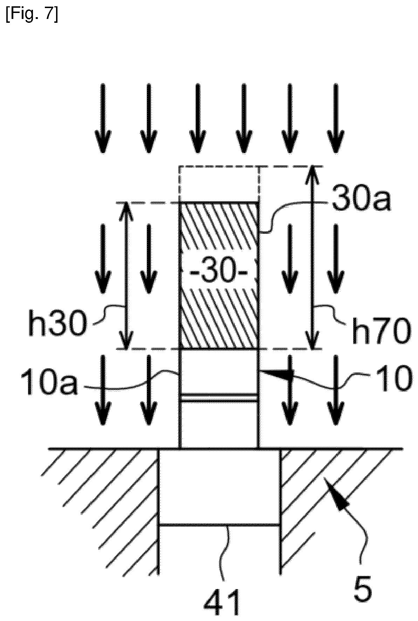

La figure 7 présente une étape 104 de délimitation de l'empilement magnétique 10' de manière à former la jonction tunnel 10. Cette délimitation 104 est réalisée par gravure anisotrope à travers un deuxième masque. La gravure est arrêtée sur le substrat 5. Dans cet exemple, la gravure est réalisée en utilisant l'espaceur 30 comme deuxième masque de gravure. L'empilement 10' est ainsi gravé dans le prolongement de l'espaceur 30. La gravure est réalisée tout en conservant une très bonne qualité d'interface entre la première couche magnétique 11' (formant maintenant la couche libre 11) et l'espaceur 30.

À l'issue de l'étape de délimitation 104 de la jonction tunnel 10, l'espaceur 30 présente son épaisseur finale h30. Lorsqu'il est utilisé comme masque de gravure, son épaisseur initiale h70 est avantageusement choisie pour qu'il présente une épaisseur finale h30 à la fin de la gravure permettant de réaliser une écriture par effet SOT. Son épaisseur initiale h70 dépend de la vitesse de gravure v30 de la couche conductrice 70, ainsi que la vitesse de gravure v10' et de la hauteur h10' de l'empilement 10'. L'épaisseur initiale h70 est par exemple sensiblement égale à :
$h 70 \approx h 10 ′ \times v 30 / v 10 ′ + h 30$

Par « sensiblement égale » ou par le signe '≈', on entend égale à 20 % près, voire 10 % prés.

Puisque l'épaisseur h30 de l'espaceur 30 doit être inférieure à la longueur de diffusion δ pour permettre l'effet SOT, l'épaisseur initiale h70 de la couche conductrice est, selon l'invention, inférieure à :
$h 70 < h 10 ′ \times v 30 / v 10 ′ + δ$

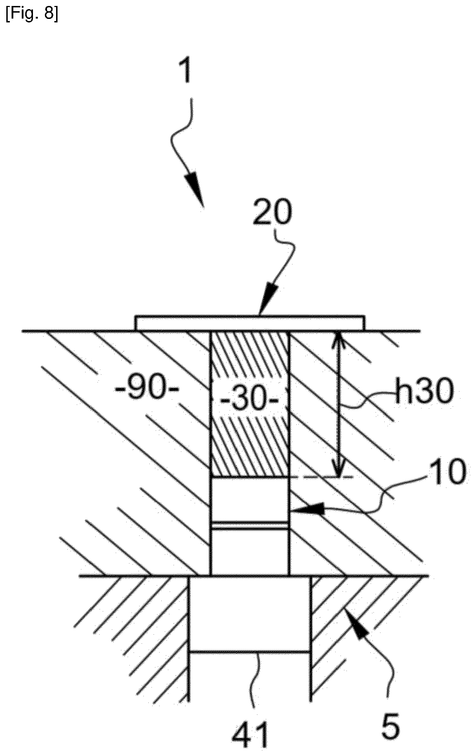

La figure 8 présente schématiquement la formation 105 de la piste SOT 20. Elle comprend dans un premier temps une sous-étape de dépôt d'une couche diélectrique 90 affleurant le sommet de l'espaceur 30 (c'est-à-dire la partie libre de l'espaceur 30). Cette couche diélectrique 90 est par exemple déposée en recouvrant la jonction 10 et l'espaceur 30. Ensuite un polissage mécanique et/ou chimique avec arrêt sur le sommet de l'espaceur 30 permet de libérer ce dernier de la couche diélectrique 90. La couche diélectrique 90 comprend par exemple du SiO₂. Une sous-étape de dépôt du matériau destiné à former la piste SOT 20, par exemple un métal de transition lourd ou un matériau 2D ou un isolant topologique ou un matériau supraconducteur, est déposé sur l'espaceur 30 et la couche diélectrique 90. Le dépôt est réalisé à travers un masque ou la couche est gravée à travers un masque, ou encore le matériau peut est reporté pour former la piste SOT 20. La piste SOT 20 s'étend à plat (c'est-à-dire sensiblement parallèle au substrat 5), en partie contre l'espaceur 30 et en partie sur la couche diélectrique 90.

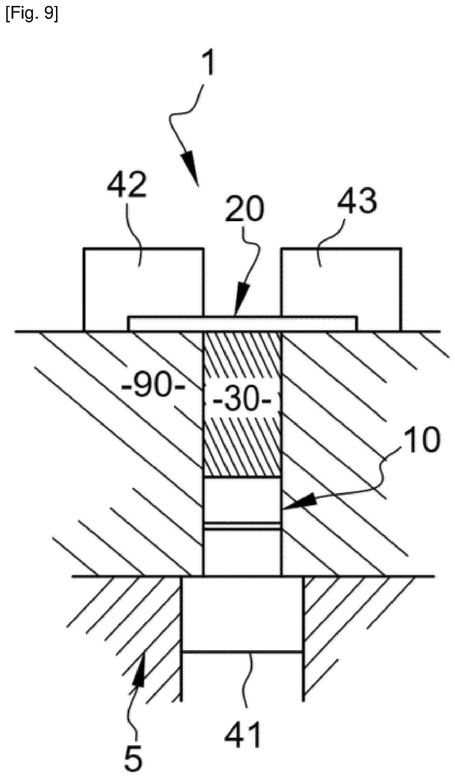

La figure 9 présente schématiquement la formation 106 des deuxième et troisième terminaux 42, 43. Ils sont obtenus par dépôt, à travers un masque, d'un métal de manière à connecter chacun une extrémité de la piste SOT 20. Les deuxième et troisième terminaux 42, 43 peuvent également prendre la forme de vias remontant du substrat 5 jusqu'à la piste SOT 20.

Pour former la mémoire 1 de la figure 2, l'étape de formation de la piste SOT 20 diffère de l'étape illustrée par la figure 8 en ce que la couche diélectrique 90 n'est pas aplanie par polissage. Elle présente au contraire une différence de hauteur de part et d'autre de la première partie 1a de la mémoire 1. La couche diélectrique 90 présente, sur un côté seulement de la première partie 1a, une hauteur supérieure à celle de l'espaceur 30. La couche diélectrique 90 offre ainsi une surface, s'étendant dans le prolongement du flanc de la première partie 1a, sur laquelle peut s'étendre la deuxième portion 22 de la piste SOT 20. La différence de hauteur de la couche diélectrique 90 est par exemple obtenu par gravure. La gravure est réalisée par de manière à former un flanc 91 de la couche diélectrique 90 qui s'étend dans le prolongement d'une partie du flanc 30a de l'espaceur 30. La piste SOT 20 peut ensuite être réalisée par dépôt conforme contre l'espaceur 30 et le flanc 91 perpendiculaire au substrat 5.

Pour former la mémoire 1 de la figure 3, les étapes de formation de la piste SOT 20 et de formation des deuxième et troisième terminaux 42, 43 sont modifiées et inversées.

Dans un premier temps, le procédé de fabrication comprend une étape supplémentaire de formation de la couche isolante 60 sur le flanc 10a, 30a de la jonction tunnel 10 et de l'espaceur 30. Cette couche isolante 60 est par exemple obtenue par dépôt conforme d'un film d'oxyde. Elle peut également être obtenue par dépôt conforme d'un film semiconducteur qui est, dans un second temps, oxydé thermiquement. Une gravure anisotrope ou une planarisation chimique et physique de ce film conforme permet de dégager la face supérieure de l'espaceur 30.

Dans un second temps, la première sous-étape de formation 105 de la piste SOT 20 consistant à déposer la couche diélectrique 90 est réalisée de manière à ne laisser dégager qu'une portion de la hauteur de la première partie 1a.

Les deuxième et troisième terminaux 42, 43 sont ensuite formés de part et d'autre de l'espaceur 30, en appui contre la couche isolante 60. Les terminaux 42, 43 sont formés de manière à dépasser l'espaceur 30. En d'autres termes, ils forment les parois 52a, 43a d'une tranchée dont l'espaceur 30 est le fond. Enfin, la deuxième sous-étape de formation 105 de la piste SOT 20 consistant à déposer le matériau destiné à former la piste SOT 20 (par exemple du Pt ou du Nb) est réalisé dans la cavité formée par les terminaux 42, 43.

Alternativement, lorsque les deuxième et troisième terminaux sont formés à hauteur de l'espaceur 30, c'est-à-dire affleurant le sommet de l'espaceur 30 sur l'espaceur 30 et la couche diélectrique 90. Le dépôt de la piste SOT 20 permet d'obtenir une piste sensiblement parallèle au plan des couches.

## Revendications

1. Procédé de fabrication d'une mémoire (1) à effet de couple de spin, dite « mémoire SOT », comprenant, à partir d'un substrat (5), les étapes suivantes :
- déposer (101) un empilement magnétique (10') destiné à former, après délimitation, une jonction tunnel magnétique (10), l'empilement magnétique comprenant une première couche magnétique (11') présentant, après délimitation, une aimantation libre ;
- déposer (102) une couche conductrice (70) sur l'empilement magnétique et directement contre la première couche magnétique, la couche conductrice présentant une longueur de diffusion de spin ;
- graver (103) un espaceur (30) dans la couche conductrice de manière anisotrope à travers un premier masque de gravure (80) avec arrêt sur l'empilement magnétique ;
- graver (104) l'empilement magnétique de manière à délimiter la jonction tunnel magnétique, la gravure étant réalisée de manière anisotrope en employant l'espaceur comme deuxième masque de gravure, l'espaceur (30) présentant, après gravure, un épaisseur finale (h30) inférieure à sa longueur de diffusion de spin ; et
- former, sur l'espaceur (30) et directement contre cet espaceur, une piste (20), dite « piste SOT », à partir d'un matériau présentant un couplage spin-orbite, la couche conductrice (70) présentant une épaisseur initiale h70 donnée par : $h 70 < h 10 ′ \times v 30 / v 10 ′ + δ$ où h10' est l'épaisseur de l'empilement magnétique (10'), v10' est la vitesse de gravure de l'empilement magnétique, v30 est la vitesse de gravure de la couche conductrice et δ est la longueur de diffusion de spins de la couche conductrice, les vitesses de gravure de l'empilement magnétique et de la couche conductrice étant considérées pour des conditions de gravure identiques.

2. Procédé selon la revendication précédente, selon lequel la couche conductrice (70) présente une longueur de diffusion de spin supérieure à 20 nm.

3. Procédé selon la revendication précédente, selon lequel la couche conductrice (70) comprend un matériau parmi Cu, AI, Ag, Co, Au ou Ni.

4. Procédé selon l'une des revendications précédentes, selon lequel l'espaceur (30) présente une épaisseur finale (h30) supérieure à 10 nm.

5. Procédé selon l'une des revendications précédentes, selon lequel l'espaceur (30) présente une vitesse de gravure (v30) inférieure à la vitesse de gravure (v10') de l'empilement magnétique (10'), les vitesses de gravure de l'espaceur et de l'empilement magnétique étant considérées pour des conditions de gravure identiques.

6. Procédé selon la revendication précédente, selon lequel l'espaceur (30) comprend un alliage durci de Cu, AI, Ag, Co, Au ou Ni, tel que AgCd, CuW ou CuBr.

7. Procédé selon l'une des revendications précédentes, selon lequel la couche conductrice (70) est une multicouche.

8. Procédé selon la revendication précédente, selon lequel la multicouche alterne une première couche présentant une vitesse de gravure inférieure à la vitesse de gravure (v10') de l'empilement magnétique (10') et une deuxième couche présentant une longueur de diffusion de spin supérieure à 20 nm, les vitesses de gravure des premières et deuxièmes couches étant considérées pour des conditions de gravure identiques.

9. Procédé selon l'une des revendications précédentes, selon lequel la première couche magnétique (11') présente, après délimitation, une anisotropie magnétique perpendiculaire.

10. Procédé selon l'une des revendications 1 à 9, selon lequel la formation (105) de la piste SOT (20) comprend les sous-étapes de :
- déposer une couche diélectrique (90) recouvrant l'espaceur (30) ;
- aplanir la couche diélectrique avec arrêt sur le sommet de l'espaceur ;
- déposer la piste SOT (20) s'étendant en partie sur la couche diélectrique et en partie sur l'espaceur.

11. Procédé selon l'une des revendications 1 à 9, selon lequel la formation (105) de la piste SOT (20) comprend les sous-étapes de :
- déposer une couche diélectrique (90) recouvrant l'espaceur (30) ;
- graver une partie de la couche diélectrique avec arrêt sur le sommet de l'espaceur de sorte que la couche diélectrique présente un flanc (91) s'étendant perpendiculairement au substrat (5), dans le prolongement d'une partie d'un flanc (30a) de l'espaceur ;
- déposer la piste SOT (20) s'étendant en partie sur la couche diélectrique et en partie sur l'espaceur, la piste SOT présentant deux portions consécutives (21, 22), l'une des portions (21), dite « portion parallèle » s'étendant sur l'espaceur, sensiblement parallèlement au substrat et l'autre des portions (22), dite « portion perpendiculaire » s'étendant contre le flanc de la couche diélectrique, sensiblement perpendiculairement au substrat.

12. Procédé selon l'une des revendications 1 à 9, selon lequel la formation (105) de la piste SOT (20) comprend les sous-étapes de :
- déposer une couche isolante (60) contre le flanc (30a) de l'espaceur (30) ;
- former une couche diélectrique (90) en laissant dégagée une portion l'espaceur ;
- former un premier terminal conducteur (42) et un deuxième terminal conducteur (43) sur la couche diélectrique, de part et d'autre de l'espaceur, s'appuyant contre la couche isolante, les premier et deuxième terminaux étant distant l'un de l'autre ;
- former la piste SOT (20) s'étendant sur l'espaceur en reliant électriquement les premier et deuxième terminaux.

13. Procédé selon la revendication 12, selon lequel les premier et deuxième terminaux (42, 43) sont formés de manière à créer respectivement une première paroi (42a) et une deuxième paroi (43a), disposées de part et d'autre de l'espaceur (30), s'étendant sensiblement perpendiculairement au substrat (5) et formant une tranchée avec l'espaceur, la piste SOT (29) étant déposée dans la tranchée.

14. Procédé selon la revendication 12, selon lequel la formation (105) de la piste SOT (20) comprend la sous-étape complémentaire d'aplanir les premier et deuxième terminaux (42, 43) avec arrêt au sommet de l'espaceur (30), la piste SOT étant sensiblement parallèlement au substrat (5), en partie sur les premier et deuxième terminaux et en partie sur l'espaceur.

15. Mémoire (1) à effet de couple spin-orbite, dite « mémoire SOT », comprenant, à partir d'un substrat (5) :
- une jonction tunnel magnétique (10) s'étendant sur le substrat, comprenant une première couche magnétique, dite « couche libre », présentant une aimantation libre, la jonction tunnel magnétique (10) étant « bottom-pinned » ;
- une piste (20), dite « piste SOT », présentant un couplage spin-orbite ; et
- une couche conductrice (30), dite « espaceur », séparant la jonction tunnel de la piste SOT et s'étendant directement contre la couche libre et directement contre la piste SOT, l'espaceur présentant une longueur de diffusion de spin strictement supérieure à son épaisseur,
la mémoire SOT étant **caractérisée en ce que** l'espaceur (30) présente une épaisseur finale (h30) supérieure à 10 nm.

## Patentansprüche

1. Verfahren zur Herstellung eines Speichers (1) mit Spin-Kopplungseffekt, auch "SOT-Speicher" genannt, das ausgehend von einem Substrat (5) die folgenden Schritte umfasst:
- Aufbringen (101) eines magnetischen Schichtenstapels (10'), der dazu bestimmt ist, nach der Abgrenzung einen magnetischen Tunnelübergang (10) zu bilden, wobei der magnetische Schichtenstapel eine erste magnetische Schicht (11') umfasst, die nach der Abgrenzung eine freie Magnetisierung aufweist;
- Aufbringen (102) einer leitenden Schicht (70) auf den magnetischen Schichtenstapel und direkt an die erste magnetische Schicht, wobei die leitende Schicht eine Spin-Diffusionslänge aufweist;
- Ätzen (103) eines Abstandshalters (30) in die leitende Schicht in anisotroper Weise durch eine erste Ätzmaske (80) mit Begrenzung auf den magnetischen Schichtenstapel;
- Ätzen (104) des magnetischen Schichtenstapels derart, dass der magnetische Tunnelübergang begrenzt wird, wobei das Ätzen anisotrop unter Verwendung des Abstandshalters als zweite Ätzmaske erfolgt und der Abstandshalter (30) nach dem Ätzen eine Enddicke (h30) aufweist, die kleiner ist als seine Spin-Diffusionslänge; und
- Bilden einer als "SOT-Leiterbahn" bezeichneten Leiterbahn (20) auf dem Abstandhalter (30) und direkt an diesem Abstandhalter aus einem Material, das eine Spin-Orbit-Kopplung aufweist,
wobei die leitende Schicht (70) eine Anfangsdicke h70 aufweist, die durch folgende Gleichung gegeben ist: $h 70 < h 10 ′ \times v 30 / v 10 ′ + δ$
wobei h10' die Dicke des magnetischen Schichtenstapels (10') ist, v10' die Ätzgeschwindigkeit des magnetischen Schichtenstapels ist, v30 die Ätzgeschwindigkeit der leitenden Schicht ist und δ die Spin-Diffusionslänge der leitenden Schicht ist, wobei die Ätzgeschwindigkeiten des magnetischen Schichtenstapels und der leitenden Schicht unter identischen Ätzbedingungen betrachtet werden.

2. Verfahren nach dem vorstehenden Anspruch, nach dem die leitende Schicht (70) eine Spin-Diffusionslänge von mehr als 20 nm aufweist.

3. Verfahren nach dem vorstehenden Anspruch, nach dem die leitende Schicht (70) ein Material aus der Gruppe Cu, Al, Ag, Co, Au oder Ni umfasst.

4. Verfahren nach einem der vorstehenden Ansprüche, nach dem der Abstandshalter (30) eine Enddicke (h30) von mehr als 10 nm aufweist.

5. Verfahren nach einem der vorstehenden Ansprüche, nach dem der Abstandshalter (30) eine Ätzgeschwindigkeit (v30) aufweist, die geringer ist als die Ätzgeschwindigkeit (v10') des magnetischen Schichtenstapels (10'), wobei die Ätzgeschwindigkeiten des Abstandshalters und des magnetischen Schichtenstapels unter identischen Ätzbedingungen betrachtet werden.

6. Verfahren nach dem vorstehenden Anspruch, nach dem der Abstandshalter (30) eine gehärtete Legierung aus Cu, Al, Ag, Co, Au oder Ni umfasst, wie beispielsweise AgCd, CuW oder CuBr.

7. Verfahren nach einem der vorstehenden Ansprüche, nach dem die leitende Schicht (70) ein Mehrschichtaufbau ist.

8. Verfahren nach dem vorstehenden Anspruch, nach dem der Mehrschichtaufbau abwechselnd eine erste Schicht, die eine Ätzgeschwindigkeit aufweist, die geringer ist als die Ätzgeschwindigkeit (v10') des magnetischen Schichtenstapels (10'), und eine zweite Schicht, die eine Spin-Diffusionslänge von mehr als 20 nm aufweist, umfasst, wobei die Ätzgeschwindigkeiten der ersten und zweiten Schichten unter identischen Ätzbedingungen betrachtet werden.

9. Verfahren nach einem der vorstehenden Ansprüche, nach dem die erste magnetische Schicht (11') nach der Abgrenzung eine senkrechte magnetische Anisotropie aufweist.

10. Verfahren nach einem der Ansprüche 1 bis 9, nach dem die Bildung (105) der SOT-Leiterbahn (20) die folgenden Teilschritte umfasst:
- Aufbringen einer den Abstandshalter (30) bedeckenden dielektrischen Schicht (90);
- Planieren der dielektrischen Schicht bis zur Oberkante des Abstandshalters;
- Aufbringen der SOT-Leiterbahn (20), die sich teilweise auf der dielektrischen Schicht und teilweise auf dem Abstandshalter erstreckt.

11. Verfahren nach einem der Ansprüche 1 bis 9, nach dem die Bildung (105) der SOT-Leiterbahn (20) die folgenden Teilschritte umfasst:
- Aufbringen einer den Abstandshalter (30) bedeckenden dielektrischen Schicht (90);
- Ätzen eines Teils der dielektrischen Schicht bis zur Oberkante des Abstandshalters, so dass die dielektrische Schicht eine Flanke (91) aufweist, die sich senkrecht zum Substrat (5) in der Verlängerung eines Teils einer Flanke (30a) des Abstandshalters erstreckt;
- Aufbringen der SOT-Leiterbahn (20), die sich teilweise auf der dielektrischen Schicht und teilweise auf dem Abstandshalter erstreckt, wobei die SOT-Leiterbahn zwei aufeinanderfolgende Abschnitte (21, 22) aufweist, wobei sich einer der Abschnitte (21), der als "paralleler Abschnitt" bezeichnet wird, über den Abstandshalter im Wesentlichen parallel zum Substrat erstreckt und der andere der Abschnitte (22), der als "senkrechter Abschnitt" bezeichnet wird, an der Flanke der dielektrischen Schicht im Wesentlichen senkrecht zum Substrat verläuft.

12. Verfahren nach einem der Ansprüche 1 bis 9, nach dem die Bildung (105) der SOT-Leiterbahn (20) die folgenden Teilschritte umfasst:
- Aufbringen einer Isolierschicht (60) an der Flanke (30a) des Abstandshalters (30);
- Bilden einer dielektrischen Schicht (90), wobei ein Abschnitt des Abstandshalters freigelassen wird;
- Bilden eines ersten leitenden Anschlusses (42) und eines zweiten leitenden Anschlusses (43) auf der dielektrischen Schicht zu beiden Seiten des Abstandshalters, die an der Isolierschicht anliegen, wobei der erste und der zweite Anschluss voneinander beabstandet sind;
- Bilden der SOT-Leiterbahn (20), die sich über den Abstandshalter erstreckt und den ersten und den zweiten Anschluss elektrisch verbindet.

13. Verfahren nach Anspruch 12, nach dem der erste und der zweite Anschluss (42, 43) so ausgebildet sind, dass sie jeweils eine erste Wand (42a) und eine zweite Wand (43a) bilden, die zu beiden Seiten des Abstandshalters (30) angeordnet sind und sich im Wesentlichen senkrecht zum Substrat (5) erstrecken und mit dem Abstandshalter einen Einschnitt bilden, wobei die SOT-Leiterbahn (29) in dem Einschnitt aufgebracht wird.

14. Verfahren nach Anspruch 12, nach dem die Bildung (105) der SOT-Leiterbahn (20) den zusätzlichen Teilschritt umfasst, die ersten und zweiten Anschlüsse (42, 43) bis zur Oberkante des Abstandshalters (30) zu planieren, wobei die SOT-Leiterbahn im Wesentlichen parallel zum Substrat (5) verläuft, teilweise auf dem ersten und zweiten Anschluss und teilweise auf dem Abstandshalter.

15. Speicher (1) mit Spin-Orbit-Kopplungseffekt, auch "SOT-Speicher" genannt, der ausgehend von einem Substrat (5) umfasst:
- einen magnetischen Tunnelübergang (10), der sich über das Substrat erstreckt und eine erste magnetische Schicht, die sogenannte "freie Schicht", mit einer freien Magnetisierung umfasst, wobei der magnetische Tunnelübergang (10) "bottom-pinned" ist;
- eine als "SOT-Leiterbahn" bezeichnete Leiterbahn (20), die eine Spin-Orbit-Kopplung aufweist; und
- eine als "Abstandshalter" bezeichnete leitende Schicht (30), die den Tunnelübergang von der SOT-Leiterbahn trennt und sich direkt an die freie Schicht sowie direkt an die SOT-Leiterbahn anschließt, wobei der Abstandshalter eine Spin-Diffusionslänge aufweist, die deutlich größer ist als seine Dicke,
wobei der SOT-Speicher **dadurch gekennzeichnet ist, dass** der Abstandshalter (30) eine Enddicke (h30) von mehr als 10 nm aufweist.

## Claims

1. A method for manufacturing a spin-orbit torque memory (1), referred to as an "SOT memory", comprising, starting from a substrate (5), the following steps of:
- depositing (101) a magnetic stack (10') for forming, after delimitation, a magnetic tunnel junction (10), the magnetic stack comprising a first magnetic layer (11') exhibiting, after delimitation, a free magnetisation;
- depositing (102) a conductive layer (70) onto the magnetic stack and directly against the first magnetic layer, the conductive layer having a spin diffusion length;
- anisotropically etching (103) a spacer (30) into the conductive layer through a first etching mask (80) with stopping on the magnetic stack;
- etching (104) the magnetic stack so as to delimit the magnetic tunnel junction, etching being carried out anisotropically employing the spacer as a second etching mask, the spacer (30) exhibiting, after etching, a final thickness (h30) less than its spin diffusion length; and
- forming, on the spacer (30) and directly against this spacer, a so-called "SOT track" (20), from a material exhibiting spin-orbit coupling, the conductive layer (70) having an initial thickness h70 given by: $h 70 < h 10 ′ \times v 30 / v 10 ′ + δ$
where h10' is the thickness of the magnetic stack (10'), v10' is the etch rate of the magnetic stack, v30 is the etch rate of the conductive layer and δ is the spin diffusion length of the conductive layer, the etch rates of the magnetic stack and the conductive layer being considered for identical etching conditions.

2. The method according to the preceding claim, wherein the conductive layer (70) has a spin diffusion length greater than 20 nm.

3. The method according to the preceding claim, wherein the conductive layer (70) comprises one material of Cu, Al, Ag, Co, Au or Ni.

4. The method according to one of the preceding claims, wherein the spacer (30) has a final thickness (h30) greater than 10 nm.

5. The method according to one of the preceding claims, wherein the spacer (30) has an etch rate (v30) lower than the etch rate (v10') of the magnetic stack (10'), the etch rates of the spacer and of the magnetic stack being considered for identical etching conditions.

6. The method according to the preceding claim, wherein the spacer (30) comprises a hardened alloy of Cu, Al, Ag, Co, Au or Ni, such as AgCd, CuW or CuBr.

7. The method according to one of the preceding claims, wherein the conductive layer (70) is a multilayer.

8. The method according to the preceding claim, wherein the multilayer alternates a first layer having an etch rate lower than the etch rate (v10') of the magnetic stack (10') and a second layer having a spin diffusion length greater than 20 nm, the etch rates of the first and second layers being considered for identical etching conditions.

9. The method according to one of the preceding claims, wherein the first magnetic layer (11') exhibits, after delimitation, a perpendicular magnetic anisotropy.

10. The method according to one of claims 1 to 9, wherein forming (105) the SOT track (20) comprises the sub-steps of:
- depositing a dielectric layer (90) covering the spacer (30);
- flattening the dielectric layer, stopping at the top of the spacer;
- depositing the SOT track (20) extending partly over the dielectric layer and partly over the spacer.

11. The method according to one of claims 1 to 9, wherein forming (105) the SOT track (20) comprises the sub-steps of:
- depositing a dielectric layer (90) covering the spacer (30);
- etching a part of the dielectric layer with stopping on the top of the spacer so that the dielectric layer has a flank (91) extending perpendicularly to the substrate (5), as an extension of a part of a flank (30a) of the spacer;
- depositing the SOT track (20) extending partly over the dielectric layer and partly over the spacer, the SOT track having two consecutive portions (21, 22), one of the portions (21), referred to as a "parallel portion", extending over the spacer, substantially in parallel to the substrate, and the other of the portions (22), referred to as a "perpendicular portion", extending against the flank of the dielectric layer, substantially perpendicularly to the substrate.

12. The method according to one of claims 1 to 9, wherein forming (105) the SOT track (20) comprises the sub-steps of:
- depositing an insulating layer (60) against the side (30a) of the spacer (30);
- forming a dielectric layer (90) leaving a portion of the spacer free;
- forming a first conductive terminal (42) and a second conductive terminal (43) on the dielectric layer, on either side of the spacer, resting against the insulating layer, the first and second terminals being distant from each other;
- forming the SOT track (20) extending over the spacer by electrically connecting the first and second terminals.

13. The method according to claim 12, wherein the first and second terminals (42, 43) are formed so as to create a first wall (42a) and a second wall (43a) respectively, disposed on either side of the spacer (30), extending substantially perpendicularly to the substrate (5) and forming a trench with the spacer, the SOT track (29) being deposited into the trench.

14. The method according to claim 12, wherein forming (105) the SOT track (20) comprises the complementary sub-step of flattening the first and second terminals (42, 43) with stopping at the top of the spacer (30), the SOT track being substantially parallel to the substrate (5), partly over the first and second terminals and partly over the spacer.

15. A spin-orbit torque effect memory (1), referred to as a "SOT memory", comprising, from a substrate (5):
- a magnetic tunnel junction (10) extending over the substrate, comprising a first magnetic layer, referred to as a "free layer", exhibiting free magnetisation, the magnetic tunnel junction being "bottom-pinned" ;
- a track (20), referred to as a "SOT track", exhibiting spin-orbit coupling; and
- a conductive layer (30), referred to as a "spacer", separating the tunnel junction from the SOT track and extending directly against the free layer and directly against the SOT track, the spacer having a spin diffusion length strictly greater than its thickness,
the SOT memory being **characterised in that** the spacer (30) has a final thickness (h30) greater than 10 nm.
